# EUROPÄISCHE PATENTSCHRIFT

(11) **EP 0 355 194 B1**
(45) Veröffentlichungstag und Bekanntmachung des Hinweises auf die Patenterteilung: **03.11.1993**
(21) Anmeldenummer: 88113888.7
(22) Anmeldetag: 25.08.1988
(51) Int. Cl.: H05K 3/46

(54) **Verfahren zum Herstellen von durchkontaktierten Leiterplatten mit sehr kleinen oder keinen Löträndern um die Durchkontaktierungslöcher**
Process for producing bonded-through printed-circuit boards having very little or no solder edges around the through-bonding holes
Procédé de fabrication de plaques de circuit à trous traversants comportant de très petits oeillets de soudage ou n'en comportant pas autour des trous traversants

(43) Veröffentlichungstag der Anmeldung: 28.02.1990
(73) Patentinhaber: Siemens Nixdorf Informationssysteme Aktiengesellschaft, 33102 Paderborn (DE)
(72) Erfinder: Merkenschlager, Hans-Hermann, Dipl.-Ing., D-8900 Augsburg 21 (DE); Schur, Anton, D-8906 Gersthofen (DE)
(74) Vertreter: Fuchs, Franz-Josef, Dr.-Ing.

(56) Entgegenhaltungen:
- EP-A- 0 178 864
- DE-A- 3 108 080
- US-A- 4 529 477

## Beschreibung

Die Erfindung bezieht sich auf die Herstellung von durchkontaktierten Leiterplatten mit sehr kleinem Lötrand oder ohne Lötrand um die Durchkontaktierungslöcher herum unter Anwendung des Tenting-Verfahrens. Mit zunehmender Integrationsdichte durch Verwendung hochintegrierter Bausteine auf durchkontaktierten Leiterplatten ergibt sich die Notwendigkeit, die Durchkontaktierungslöcher und damit auch die um sie herum befindlichen Lötränder immer mehr zu verkleinern.

Durchkontaktierte Leiterplatten wurden bisher überwiegend in sogenannter Metallresist-Technik, nicht aber im Tenting-Verfahren hergestellt. Gegenüber dem Tenting-Verfahren, bei dem vor dem Ätzschritt das Leiterbild, die Lötaugen und die Durchkontaktierungslöcher der Leiterplatte mit Fotofolie abgedeckt werden, sind bei Anwendung der Metallresist-Technik mehr Galvanikschritte erforderlich und das Verfahren ist im ganzen nicht so automatisierungsfreudig wie das Tenting-Verfahren. Beim Tenting-Verfahren schützt die Maske aus Fotofolie während des Ätzvorganges die abgedeckten Bereiche vor dem Angriff der Ätze, während an den übrigen Stellen das Kupfer abgetragen und so die Leiterbahnstruktur erzeugt wird. Bei Anwendung des Tenting-Verfahrens ist aber ein Problem der Schutz von metallisierten Durchkontaktierungslöchern. Falls der Lötrand um die Durchkontaktierungslöcher herum zu klein wird oder sogar wegfallen kann, besteht die Gefahr, daß die das Loch abdeckende Fotofolie aufreißt, dadurch Ätze in das Durchkontaktierungsloch eindringt, die die Kupfermetallisierung in dem Durchkontaktierungsloch abträgt und damit die Durchkontaktierung selbst zerstört.

Um das Abtragen der Kupfermetallisierung in dem Durchkontaktierungsloch zu vermeiden ist schon vorgeschlagen worden, vor dem Aufbringen der Fotofolie und vor dem Ätzprozeß die Durchkontaktierungslöcher mit Siebdruckpaste zu füllen und damit gegen das Eindringen von Ätze zu schützen. Diese Methode ist aber relativ umständlich und aufwendig.

Der Erfindung lag daher die Aufgabe zugrunde, ein Verfahren zum Herstellen von durchkontaktierten Leiterplatten mit sehr kleinen oder keinen Löträndern um die Durchkontaktierungslöcher zu schaffen, bei dem das Tenting-Verfahren angewendet werden kann, dabei aber die Nachteile dieses Verfahrens bei Durchkontaktierungslöchern mit sehr kleinem oder keinem Lötrand vermieden werden. Erfindungsgemäß wird dies dadurch erreicht, daß die Leiterplatte vor dem Beschichten mit Fotofolie in eine Lösung getaucht wird, die auf allen Kupferflächen eine ätzfeste Schutzschicht erzeugt, daß diese Schutzschicht anschließend von der/den Oberfläche/n der Leiterplatte mit Ausnahme der Durchkontaktierungslöcher wieder entfernt wird, daß danach die Leiterbahnen und die Durchkontaktierungslöcher der Leiterplatte mit einer Fotofolie abgedeckt werden, daß die Leiterplatte dann geätzt wird, und daß nach dem Ätzen und nach dem Entschichten der Fotofolie die ätzfeste Schutzschicht in den Durchkontaktierungslöchern wieder entfernt wird.

Sollte bei einer auf diese Weise behandelten Leiterplatte die auf einem Durchkontaktierungsloch befindliche Fotofolie verletzt werden oder wegen des sehr kleinen oder überhaupt nicht vorhandenen Lötrandes dort nicht gut halten, dann ist die Kupfermetallisierung in dem Durchkontaktierungsloch durch die dort befindliche ätzfeste Schutzschicht auch beim Eindringen von Ätze geschützt.

Zur Erzeugung einer ätzfesten Schutzschicht in den Durchkontaktierungslöchern hat sich besonders eine Imidazollösung bewährt.

Die ätzfeste Schutzschicht kann von der/den Oberfläche/n der Leiterplatte z.B. durch Bürsten entfernt werden. Dabei verbleibt die Schutzschicht aber in den Durchkontaktierungslöchern erhalten.

Zum Entfernen der ätzfesten Schutzschicht nach dem Ätzen der Leiterplatte aus den Durchkontaktierungslöchern ist es vorteilhaft, die Leiterplatte in eine verdünnte Säure zu tauchen.

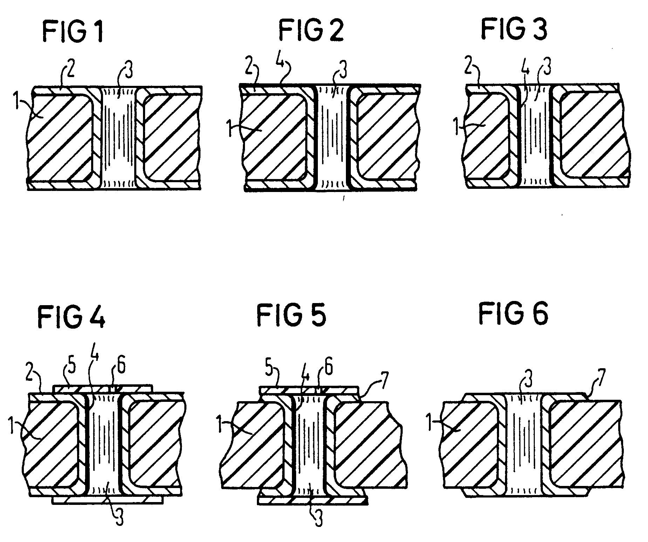

Weitere Einzelheiten der Erfindung ergeben sich aus der Erläuterung des erfindungsgemäßen Verfahrens anhand der FIG 1 bis 6.

FIG 1 zeigt als Schnittdarstellung einen Teil einer Leiterplatte 1 mit einer Kupferbeschichtung 2, die sich auch im Inneren des Durchkontaktierungsloches 3 fortsetzt. Durch Eintauchen einer solchen Leiterplatte z.B. in eine Imidazollösung bildet sich auf allen Kupferflächen 2 der Leiterplatte eine ätzfeste Schutzschicht 4, wie in FIG 2 angedeutet ist. Anschließend wird diese ätzfeste Schutzschicht von der Oberfläche der Leiterplatte z.B. durch Bürsten wieder entfernt, bleibt aber in den Durchkontaktierungslöchern 3 erhalten, wie FIG 3 zeigt. Danach werden die Leiterbahnen und die Durchkontaktierungslöcher der Leiterplatte nach dem bekannten Tenting-Verfahren mit einer Fotofolie 5 abgedeckt. Die Fotofolie 5 kann, wie FIG 4 zeigt, im Bereich eines Durchkontaktierungsloches 3 durchaus auch eine Fehlstelle besitzen, durch die Ätze in das Innere des Durchkontaktierungsloches 3 eindringen kann. Die dort befindliche Kupferfläche 2 ist aber durch die ätzfeste Schutzschicht 4 geschützt, so daß wie FIG 5 zeigt, zwar die Kupferflächen 2 ausserhalb der Fotofolie 5 entfernt wird 7, die Kupferschicht im Inneren des Durchkontaktierungsloches durch die dort vorhandene ätzfeste Schutzschicht 4 jedoch unverletzt bleibt. FIG 4 zeigt schließlich das Ergebnis des erfindungsgemäßen Verfahrens, d.h. die außerhalb des Kontaktierungsloches und seiner Lötränder weggeätzte Kupferschicht 7 und die unversehrte Durchkontaktierung 3.

## Patentansprüche

1. Verfahren zum Herstellen von durchkontaktierten Leiterplatten mit sehr kleinen oder keinen Löträndern um die Durchkontaktierungslöcher, bei dem die Leiterbahnen und/oder Durchkontaktierungslöcher mit Fotofolien abgedeckt werden,
**dadurch gekennzeichnet,**
daß die Leiterplatte (1) vor dem Beschichten mit Fotofolie (5) in eine Lösung getaucht wird, die auf allen Kupferflächen (2) eine ätzfeste Schutzschicht (4) erzeugt, daß diese Schutzschicht (4) anschließend von der/den Oberfläche/n der Leiterplatte mit Ausnahme der Durchkontaktierungslöcher (3) wieder entfernt wird, daß danach die Leiterbahnen und die Durchkontaktierungslöcher der Leiterplatte mit einer Fotofolie (5) abgedeckt werden, daß die Leiterplatte dann geätzt wird (7), und daß nach dem Ätzen und dem Entschichten der Fotofolie die ätzfeste Schutzschicht (4) in den Durchkontaktierungslöchern (3) wieder entfernt wird.

2. Verfahren nach Anspruch 1,
**dadurch gekennzeichnet,**
daß die Leiterplatte zum Erzeugen der ätzfesten Schutzschicht (4) in eine Imidazollösung getaucht wird.

3. Verfahren nach Anspruch 1 oder 2,
**dadurch gekennzeichnet,**
daß die ätzfeste Schutzschicht (4) von der/den Oberfläche/n der Leiterplatte durch Bürsten entfernt wird.

4. Verfahren nach einem der Ansprüche 1 bis 3,
**dadurch gekennzeichnet,**
daß die ätzfeste Schutzschicht (4) in den Durchkontaktierungslöchern nach dem Ätzen der Leiterplatte durch Tauchen der Leiterplatte in verdünnte Säure entfernt wird.

## Claims

1. Process for producing plated-through printed circuit boards with very small solder rims or no solder rims around the plated-through holes, in which process the conductor tracks and/or plated-through holes are covered with photographic films, characterized in that, prior to cladding with photographic film (5), the printed circuit board (1) is immersed in a solution which produces an etch-resistant protective layer (4) on all the copper surfaces (2), in that said protective layer (4) is then removed again from the surface(s) of the printed circuit board with the exception of the plated-through holes (3), in that the conductor tracks and the plated-through holes of the printed circuit board are then covered with a photographic film (5), in that the printed circuit board is then etched (7), and in that the etch-resistant protective layer (4) in the plated-through holes (3) is removed again after the etching and the stripping of the photographic film.

2. Process according to Claim 1, characterized in that the printed circuit board is immersed in an imidazole solution to produce the etch-resistant protective layer (4).

3. Process according to Claim 1 or 2, characterized in that the etch-resistant protective layer (4) is removed from the surface(s) of the printed circuit board by brushing.

4. Process according to one of Claims 1 to 3, characterized in that the etch-resistant protective layer (4) in the plated-through holes is removed after the etching of the printed circuit board by immersing the printed circuit board in dilute acid.

## Revendications

1. Procédé pour fabriquer des plaquettes à circuits imprimés à contacts traversants, comportant de très petits bords de brasage ou ne comportant aucun bord de brasage autour des trous de contact traversants, selon lequel on recouvre les voies conductrices et/ou les trous de contact traversants par des feuilles photosensibles, caractérisé par le fait qu'avant le dépôt de la feuille photosensible (5), on immerge la plaquette à circuits imprimés (1) dans une solution qui forme, sur toutes les surfaces de cuivre (2), une couche protectrice (4) résistante à la corrosion, qu'on élimine ensuite à nouveau cette couche protectrice (4) de la/des surfaces de la plaquette à circuits imprimés à l'exception des trous de contact traversants (3), qu'ensuite on recouvre avec une feuille photosensible (5) les voies conductrices et les trous de contact traversants de la plaquette à circuits imprimés, qu'on corrode ensuite (7) la plaquette à circuits imprimés et qu'après la corrosion et l'élimination de la feuille photosensible, on élimine à nouveau la couche protectrice (4) résistante à la corrosion, au niveau des trous de contact traversants (3).

2. Procédé suivant la revendication 1, caractérisé par le fait que pour l'obtention de la couche protectrice (4) résistante à la corrosion, on immerge la plaquette à circuits imprimés dans une solution de glyoxaline.

3. Procédé suivant la revendication 1 ou 2, caractérisé par le fait qu'on élimine la couche protectrice (4) résistante à la corrosion, de la/des plaquettes à circuits imprimés par brossage.

4. Procédé suivant l'une des revendications 1 à 3, caractérisé par le fait qu'après la corrosion de la plaquette à circuits imprimés, on élimine la couche protectrice (4) résistante à la corrosion, au niveau des trous de contact traversants, en immergeant la plaquette dans de l'acide dilué.
